# EUROPEAN PATENT SPECIFICATION

(11) **EP 4 186 647 B1**
(45) Date of publication and mention of the grant of the patent: **29.10.2025**
(21) Application number: 21871891.4
(22) Date of filing: 12.05.2021
(51) Int. Cl.: B25J 9/06, G01H 17/00, G01M 99/00, H01L 21/677, G01N 29/04, G01N 29/14, G01N 29/22, G01N 29/44, G01N 29/46

(54) **WAVEFORM ANALYSIS DEVICE AND WAVEFORM ANALYSIS METHOD**
WELLENFORMANALYSEVORRICHTUNG UND WELLENFORMANALYSEVERFAHREN
DISPOSITIF ET PROCÉDÉ D'ANALYSE DE FORME D'ONDE

(30) Priority: 28.09.2020 JP 2020162174
(43) Date of publication of application: 31.05.2023
(73) Proprietor: Rorze Corporation, Fukuyama-shi, Hiroshima 720-2104 (JP)
(72) Inventor: TAMATSUKURI Daigo, Fukuyama-shi, Hiroshima 720-2104 (JP)
(74) Representative: Kramer Barske Schmidtchen Patentanwälte PartG mbB
(86) International application number: PCT/JP2021/017966
(87) International publication number: WO 2022/064756

(56) References cited:
- JP-A- 2001 074 616
- JP-A- 2006 226 687
- JP-A- 2014 109 566
- US-A- 4 901 575
- US-A1- 2017 260 871
- US-A1- 2019 339 119

## Description

### [TECHNICAL FIELD]

The present invention provides an analysis device and an analysis method for diagnosing condition of machinery by detecting a sensor (hereinafter referred to as a physical sensor) that detects physical phenomena such as vibration, sound, and electromagnetic waves emitted during operation of machinery such as a multi-jointed transport robot for transporting the object to be transported or a traveling mechanism for transporting an object to be transported along a guide track. In particular, the present invention refers to a waveform analysis device and a waveform analysis method for analyzing vibration and sound signal waveforms emitted by operation of a drive mechanism such as a bearing and a feed screw mechanism provided in a moving part of an articulated robot, a rotating device such as a speed reducer, and a linear guide.

### [BACKGROUND ART]

Conventionally, methods and devices have been devised to discover deterioration of mechanical elements constituting the machinery and prevent stopping due to failure or disruptive accidents during operation. For example, JP 2-262993 A discloses a judgement means wherein a physical sensor for detecting a physical phenomenon such as sound or vibration emitted by machinery or distortion of the mechanical elements is provide, a value detected by the physical sensor is compared with a pre-stored reference value, and a deterioration signal is transmitted when the detected value is greater than or equal to the reference value. Further, there is disclosed a parts deterioration detection device for a robot that is provided with a processing means for executing a required processing operation such as issuing an alarm signal or stopping the operation of the machinery in response to a deterioration detection signal transmitted by the judgment means.

In addition, WO 2018/110337 A1 discloses an analysis device that detects obstacles by capturing impulse waveforms because an occurrence of deterioration of the machinery and collisions between mechanical elements are included as the impulse waveforms in output waveforms of physical sensors emitted by faulty machinery in which defects occurred.

US 4,901,575 A and US 2017/0260871 A1 disclose devices and methods for monitoring acoustic signals. US2019/339119 A1 discloses diagnosing a machinery state by detecting a physical phenomenon such as a sound or vibrations generated during an operation of a machinery such as an articulated robot or the like as a signal waveform.

### [DISCLOSURE OF THE INVENTION]

### [PROBLEMS TO BE SOLVED BY THE INVENTION]

According to the invention of JP 2-262993 A, in order to detect an abnormality in machinery, it is necessary to measure and register in advance actual various deterioration sounds that occur when deterioration occurs. With this method, there is a problem that it takes a considerable amount of time to research and register the various deterioration sounds in advance.

On the other hand, in WO 2018/110337 A1, an attempt is made to capture impulse waveforms instead of the deterioration sounds. Each deterioration sound is a wave generated by vibration of a mechanical element and has a frequency specific to the mechanical element. The deterioration sound can occur at various frequencies depending on a state of the mechanical element. Therefore, if an impulse waveform that does not have a specific frequency is captured, it becomes possible to detect a defect without collecting the various deterioration sounds in advance as in JP 2-262993 A.

Incidentally, collisions of the mechanical elements include "rubbing" in which the mechanical elements collide once and then separate. Cases in which the mechanical elements rub against each other can be considered as cases in which lubrication of the mechanical elements originally lubricated with lubricant runs off, or when the mechanical elements collide due to deformation, or the like. For example, when a bearing ball runs out of lubricant in a part of the ball, the part rubs against each other. Failures resulting from this repeated rubbing will occur within a relatively short period of time.

It is known that an ideal impulse waveform occurs only for an infinitely short time and contains constant amplitude value over a wide frequency band. Therefore, if Fourier transform is performed when an impulse waveform is included in detection signals of a physical sensor, a signal level should increase uniformly at all frequencies. In WO 2018/110337 A1, when evaluating Fourier transform data obtained through experiments, an increase in signal level due to the impulse waveform could not be clearly observed at relatively low frequencies because the signal was buried in the frequency of the measurement object itself. Therefore, in the invention of WO 2018/110337 A1, an operator manually set a frequency band that was rarely generated by the machinery among various vibrations generated by the measurement object, and addition was performed within a range of the frequency band. As a result, an impulse waveform that is momentarily generated when the mechanical elements rub against each other also has a spectrum in the set frequency range, so that by accumulating each impulse waveform, the impulse waveform is emphasized over a spectrum of frequency generated by natural vibrations that occur in the specific frequency range.

In WO 2018/110337 A1, since fault detection is performed by Fourier transform on an impulse waveform in which a spectrum exists at any frequency, the problem of JP 2-262993 A is solved, in which the machinery knows in advance the various types of deterioration sounds caused by abnormalities, etc., and sets the frequencies on the fault detector side to match the deterioration sounds. However, the problem remains that fault detection depends on the machinery to be detected, since it is necessary to set a frequency range that is not normally emitted by the measurement object itself. In addition, there is a need for improvement in the mechanism of the analysis device for more accurately capturing and analyzing the original impulse waveform.

The present invention has been devised in view of the above-mentioned problems, and aims to provide a method for accurately analyzing only the waveforms caused by impulses by reducing effects of vibration and deterioration sounds normally generated by machinery, no matter what frequency they have, to prevent stoppages due to machinery failures and disruptive accidents during operation due to breakdowns in the machinery without depending on the machinery, and to perform efficient maintenance work.

### [MEANS OF SOLVING THE PROBLEMS]

In order to solve the above problems, a waveform analysis device of the present invention is a waveform analysis device according to claim 1.

### [EFFECTS OF THE INVENTION]

According to the present invention, there is an effect that it is not necessary to know in advance for what frequency the natural vibration having the amplitude value is generated. That is, when the discrete Fourier transform is performed, the impulse is decomposed into a plurality of frequencies, so that the magnitude of each is smaller depending on the number of data n than the magnitude of the original impulse. On the other hand, the waveform due to the natural vibration of the machinery has a specific frequency, and even if the discrete Fourier transform is performed, the amplitude value of the specific frequency appears large almost as it is. The natural vibration can occur regardless of the presence or absence of fault, and may increase due to resonance, but the effect of natural vibration is reduced by being limited to an upper-limit value at any frequency.

### [BRIEF DESCRIPTION OF THE DRAWINGS]

[FIG. 1] FIG. 1 is a view showing a waveform analysis device.
[FIG. 2] FIGS. 2A to 2C are views for explaining an impulse. FIG. 2A is a view showing an attenuation waveform, FIG. 2B is a view for explaining a Fourier transform of the impulse, and FIG. 2C is a view showing a relationship between characteristics of a sensor unit and sampling frequency.
[FIG. 3] Each of FIG. 3A to FIG. 3D is a view showing weighting data. FIG. 3A shows weighting data W, and FIG. 3B to FIG. 3D show weighting data FL.
[FIG. 4] Each of FIG. 4A and FIG. 4B is a flowchart showing operation of an operator console and a waveform analysis device. FIG. 4A is a setting flow for setting an initial value, and FIG. 4B is a detection flow when detecting a physical phenomenon.
[FIG. 5] FIG. 5 is a perspective view showing EFEM, which is a device constituting a semiconductor manufacturing system.
[FIG. 6] Each of FIG. 6A and FIG. 6B is an example measuring vibration with respect to a fan bearing. FIG. 6A shows normal state and FIG. 6B shows abnormal state.
[FIG. 7] Each of FIG. 7A and FIG. 7B is a view showing a result of the discrete Fourier transform. FIG. 7A is the amplitude value of frequency at normal state and
FIG. 7B is the amplitude value of frequency at abnormal state.
[FIG. 8] Each of FIG. 8A to FIG. 8D is a view showing a result of the discrete Fourier transform in which sound is a measurement object. FIG. 8A is the result of the discrete Fourier transform when contact does not occur, FIG. 8B is the result of the discrete Fourier transform when it comes into contact with a tube, FIG. 8C shows the result of the discrete Fourier transform when it comes into contact with a wiring, and
FIG. 8D shows the result of the discrete Fourier transform when it comes into contact with a metal part.
[FIG. 9] Each of FIG. 9A to FIG. 9E is a view showing an example of detecting vibration when a semiconductor wafer is brought into contact, FIG. 9A is the weighting data FL used, FIGS. 9B and 9C are normal results, and FIGS. 9D and 9E are abnormal results, and the results of discrete Fourier transforms and amplitude accumulation values are shown in each order.
[FIG. 10] FIG. 10 is a view showing an example applied to other EFEMs.

### [MODE FOR CARRYING OUT THE INVENTION]

An ideal impulse waveform, that is, an impulse waveform as a delta function, is said to exist as a mathematical model but not physically as one with infinite energy in a zero width. However, in this document, discontinuous waveforms generated when mechanical elements rub against each other are referred to as impulses.

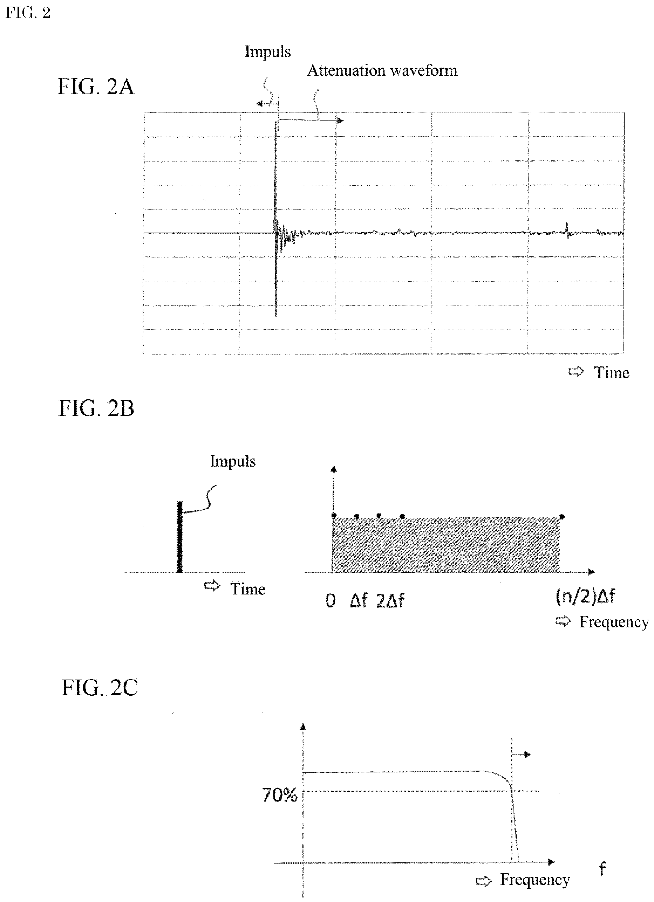

A physical sensor observes a typical attenuation waveform as shown in FIG. 2A when the mechanical elements are impacted. Such an attenuation waveform can be interpreted that discontinuous waveforms are suddenly generated at the moment when the mechanical elements are impacted, and thereafter a waveform with a specific natural frequency is generated due to structure of the mechanical elements. **In** the present invention, among detection signals observed by such a physical sensor, a first portion (waveform generated discontinuously) is defined as an impulse, and this is to be captured. Then, the attenuation waveform that follows is distinguished as being a portion that vibrates at a specific frequency. For example, this vibrating portion can be interpreted as equivalent to the deterioration sounds in the patent document 1.

The impulse observed by the physical sensor does not have infinite energy in the zero width like an ideal impulse. However, since the waveform is generated discontinuously, when frequency analysis is performed by Fourier transform, it should be analyzed as having a spectrum over a wide range of frequencies.

In a waveform analysis device of this embodiment, a known discrete Fourier transform (DFT) is performed using digital technology. The discrete Fourier transform uses n pieces of consecutive sampling data obtained by sampling continuous waves due to electrical signals detected from the physical sensor at regular intervals using an AD converter. Here, n is set to a power of two because it is advantageous for high-speed calculation by a Fourier transform algorithm. Assuming that the sampling frequency is fs, n is decomposed into n/2 (Δf, 2Δf, . . . (n/2)Δf) frequencies and DC components by the discrete Fourier transform. Besides, Δf = fs / n. In FIG. 2B, when n pieces of data are acquired at a certain sampling frequency fs, if an impulse waveform in which significant data appears only in one of the n pieces of sampling data as shown in FIG. 2B is detected, the amplitude can be calculated to be almost constant for each frequency by performing the discrete Fourier transform.

In the waveform analysis device of this embodiment, calculation is performed to find a value obtained by accumulating these amplitude values. This "accumulation" method can be obtained by finding an area of hatched portion in FIG. 2B, or by adding up the amplitude values of each frequency. When "amplitude value" is used to refer to an output of the accumulation section, power spectrum equivalent to squared amplitude value and linear spectrum which is a square root thereof are included.

Further, in the waveform analysis device of this embodiment, in order to accurately capture impulse components, discrete Fourier transform is performed using 1+kth to n+kth sampling data after 1st to nth sampling data instead of performing discrete Fourier transform on 1st to nth sampling data and then on 1+kth to n+kth sampling data. Here, k is a numerical value from 1 to n/16, and k=1 is most preferable. Also, in the waveform analysis device of this embodiment, n is preferably a power of two of 256 or more. In the case of n=256, the frequency can be decomposed into 128 pieces, which is sufficient to measure the impulses, but if the value of n is too small, it becomes difficult to measure the impulses.

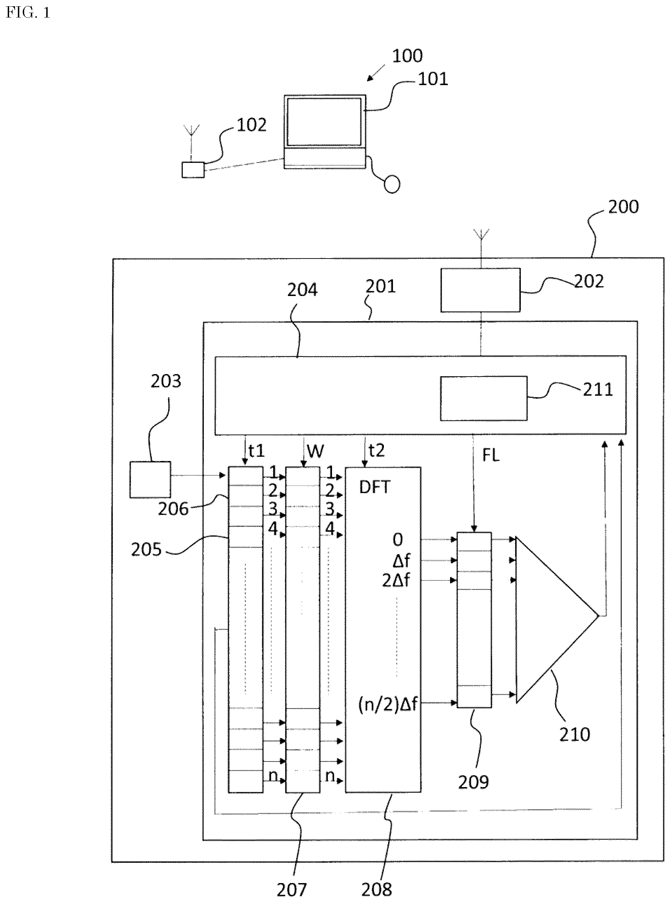

In FIG. 1, a waveform analysis device 200 of the present embodiment is installed in machinery, and includes a sensor unit (physical sensor) 203 that measures a physical phenomenon of a mechanical element to be measured, an arithmetic unit 201 composed of a gate array and a microprocessor, and a remote side communication unit 202 that wirelessly transmits and receives data. The waveform analysis device 200 is connected to an operator console 100. The operator console 100 is a general integrated computer (so-called notebook computer) having a monitor and an input device, and further includes a main body side communication unit 102 capable of wireless communication with the remote side communication unit 202.

In the figure, the arithmetic unit 201 is divided into functional blocks. The arithmetic unit 201 includes a control unit 204, a shift store unit 205, a front-stage weighting unit 207, a discrete Fourier transform unit 208, a later-stage weighting unit 209, and an accumulation unit 210. The control unit 204 gives a timing signal t1 to the shift store unit 205 every sampling period (1/fs), and the shift store unit 205 samples signal waveforms from the sensor unit. The shift store unit 205 includes n consecutive storage portions 206, and sends data to the next stage in order for each sampling period. The shift store unit 205 further outputs sampling data stored by the n consecutive storage portions 206 in parallel. Further, sampling data is output from a storage portion 206 located in the center of the shift store unit 205 and sent to the control unit 204. The reason why the storage portion 206 located at the center is selected is that the front-stage weighting unit 207, which will be described later, may give the highest weight to the output data. The control unit 204 has a memory 211 to have a storage area larger than the amount of sampling data that the shift store unit 205 can hold, so that data over several hours can be held. In addition, the sampling data is overwritten and continuously updated. Upon request from the operator console 100, the stored sampling data can be transferred.

The front-stage weighting unit 207 receives sampling data in parallel from the shift store unit 205, appropriately weights each sampling data, and passes each sampling data in parallel to the discrete Fourier transform unit 208.

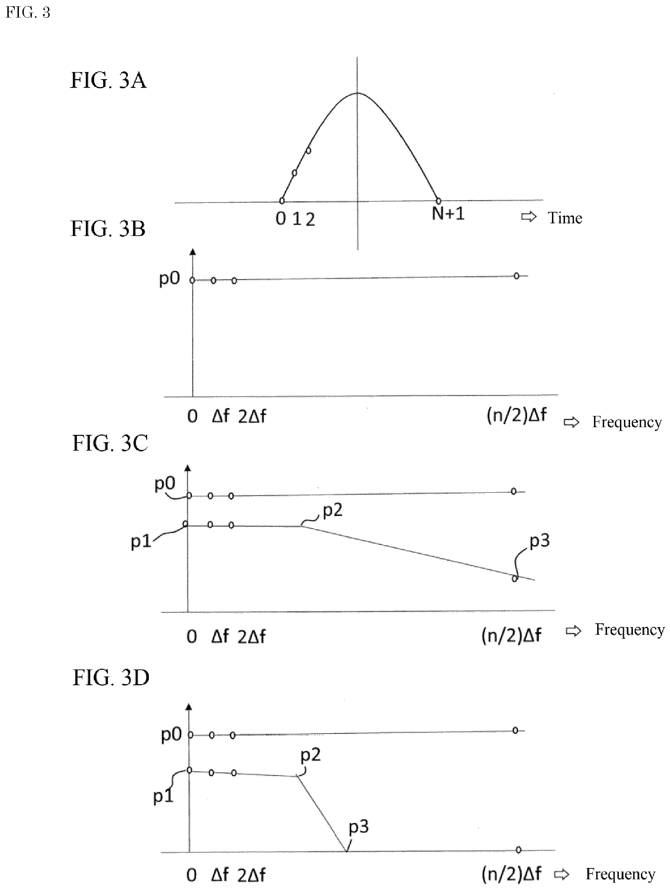

The front-stage weighting unit 207 receives weighting data W from the control unit in advance. The weighting data W is called a so-called "window function" and has a function of multiplying weighting by each sampling data. FIG. 3A shows an example of a window function. The window function is considered to be a function that is zero outside a certain finite interval, and is a mountain-shaped weighting with a convex center. For the sampling data from 1 to n, increase the weighting for the sampling data at the center position and decrease the weighting at both ends. According to providing the front-stage weighting unit, a problem that occurs when a waveform having a very long period is detected in the sensor unit can be avoided. This problem can be explained as follows. For example, when the sampling frequency fs = 2 KHz and the number of data n = 256, the time window length n/fs is 128 msec. If a waveform having a period near 128 msec is detected by the sensor unit, one period does not fit within a range of 128 msec and becomes discontinuous. When such discontinuous sampling data exists, it will be detected as an impulse. Such a problem can be avoided by the front-stage weighting unit. If such a waveform having a long period is not assumed, the shift store unit 205 and the discrete Fourier transform unit 208 may be directly connected without providing the front-stage weighting unit 207.

The discrete Fourier transform unit 208 receives a timing signal t2, calculates and outputs n/2 (Δf, 2Δf, . . . (n/2)Δf) frequency components and DC components. The timing signal t2 is generated at a period of r times (r is a positive integer) of the sampling period (1/fs) (referred to as a calculation period (CL). That is, the control unit 204 indicates whether calculation of the discrete Fourier transform unit 208 is performed at the same period as the sampling period (1/fs) (in the case of r = 1), a slow period (in the case of r = n/16), or at any timing in between them.

The later-stage weighting unit 209 receives the amplitude values of each frequency component and DC component from the discrete Fourier transform unit 208, performs appropriate weighting, and sends each amplitude value to the accumulation unit 210 in parallel. The accumulation unit 210 adds each amplitude value and sends the added value to the control unit 204 as an amplitude accumulation value. As for the amplitude accumulation value, a new value is sent to the control unit 204 for each calculation period CL.

The later-stage weighting unit 209 receives the weighting data FL from the control unit 204 in advance. The weighting data FL is weighted with respect to the amplitude value obtained from the discrete Fourier transform unit 208. FIGS. 3B, 3C, and 3D show a weighting pattern.

FIG. 3B shows weighted data that limits the upper-limit value for amplitude values above a prescribed height. This will be referred to as "upper-limit weight". The upper-limit value may be determined for each frequency, but in the present embodiment, the maximum value is limited to p0 as a common upper-limit value in each frequency. (Besides, in the following, p0 indicates amplitude value.) When a discrete Fourier transform is performed, an impulse is decomposed into a plurality of frequencies, so that the magnitude of each becomes smaller than the magnitude of the original impulse, depending on the number of data n. On the other hand, the waveform due to natural vibration of the machinery has a specific frequency, and even if a discrete Fourier transform is performed, the amplitude value of the specific frequency appears large almost as it is. The natural vibration can occur regardless of the presence or absence of obstacles, and can also become larger due to resonance. By limiting the upper-limit value at any frequency, it is not necessary to know in advance for what frequencies natural vibrations with amplitude value will occur.

FIG. 3C shows that in addition to the "upper-limit weight" of FIG. 3B, the weighting that changes depending on the frequency is subtracted, and if it becomes negative, it is set to zero. This will be referred to as "subtraction weight". In this subtraction weight, a gradient from the DC component 0 to a certain frequency mΔf and a gradient from the frequency mΔf to the frequency (n/2)Δf are changed. The gradient from the DC component 0 to mΔf is ((p2-p1)/m), and the gradient from the frequency mΔf to the frequency (n/2)Δf is ((p3-p2)/(n-m)). (Besides, in the following, p1, p2 and p3 indicate amplitude values.) In the example shown in FIG. 3C, p1 = p2, and at low frequencies, the subtraction value is kept constant.

In FIG. 3D, the gradient from the DC component 0 to mΔf is the same as in FIG. 3C, but the weight data to be subtracted is zero on the way from the frequency mΔf to the frequency (n/2)Δf. The "subtraction weight" is to reduce the amplitude value of each frequency that normally occurs in the background as the equipment operates, and depends on the equipment.

In FIGS. 3C and 3D, for example, if an amplitude value of a certain frequency is px, when px is greater than p0, then the amplitude value of the frequency is limited to p0 by the "upper-limit weight" and is subtracted by the amount determined by the "subtraction weight" or made zero.

The "upper-limit weight" does not have to be a constant value of p0 (slope 0), and may have a positive or negative slope. Also, the "subtraction weight" does not have to change slope at one point in p2, and can also change at a plurality of points, but the inventor's experiments have shown that a simple pattern is sufficient for the "upper-limit weight" and the "subtraction weight". The weighting data FL is set in advance from the control unit 204 to the later-stage weighting unit 209. By providing the later-stage weighting unit 209, the accuracy for detecting impulses can be improved.

The sensor unit 203 is a sensor that detects physical phenomena such as vibration, sound, and electromagnetic waves, and performs A/D conversion on a detection value obtained analogously and outputs it as a digital value. It is known that analog sensors have a response frequency. The response frequency is generally said to be a frequency that drops to about 70% (strictly speaking, 1/√2) of the DC frequency, with the DC frequency being 100%. FIG. 2C shows the characteristics of the sensor unit as an example. On the other hand, the sampling frequency fs is set to a frequency higher than the response frequency in order to capture short waveforms of impulses. However, if the sampling frequency is set too high, the signal will be attenuated so much that it may not be possible to perform correct calculations. Therefore, the sampling frequency fs should be about twice the response frequency.

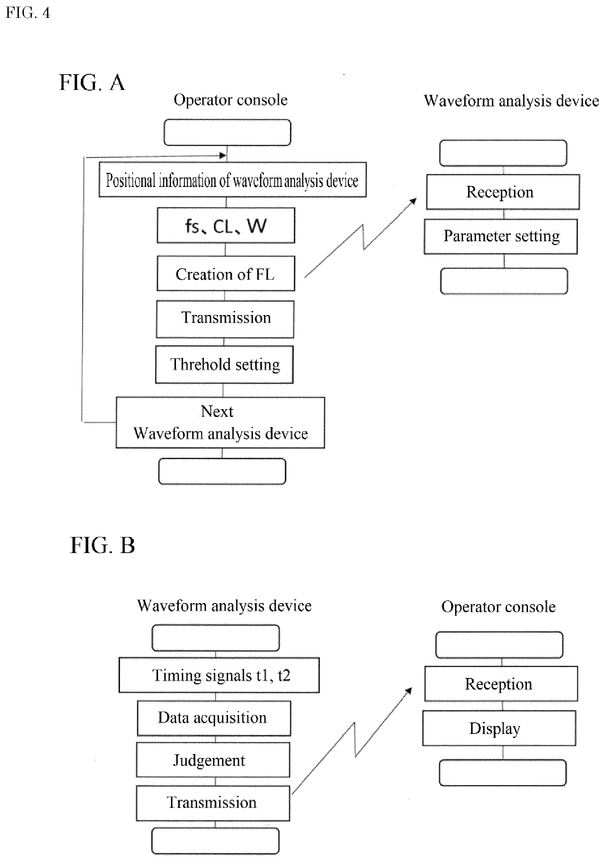

Each of FIG. 4A and FIG. 4B is a flowchart showing the operation of the operator console 100 and the waveform analysis device 200, FIG. 4A is a setting flow for setting an initial value, and FIG. 4B is a detection flow when detecting the physical phenomenon.

In FIG. 4A, the operator sets the initial value on the waveform analysis device 200 using the operator console 100. The waveform analysis device 200 includes a sensor unit 203 having a function suitable for use in order to detect physical phenomena such as vibration, sound, and electromagnetic waves. Vibration has a lower frequency than sound. In the sensor unit 203 for detecting vibration, a sampling frequency of several KHz is used, and for detecting sound, a sampling frequency of several tens of KHz is used. In this embodiment, the arithmetic unit 201 of each waveform analysis device 200 uses a member having a common configuration in consideration of cost. It is desirable that the calculation period CL and the sampling period should be the same, but in sound, the ability to calculate by the discrete Fourier transform may not keep up. The waveform analysis device 200 sets the calculation period CL and the sampling period separately, so that the calculation period CL can be set to a value slower than the sampling period.

In a setting flow, each waveform analysis device 200 is set. The operator console 100 is first populated with positional information on where each of waveform analysis device 200 is mounted. The positional information is associated with various measurement objects, for example, bearings. Next, parameters such as sampling frequency fs and calculation are input to the specific waveform analysis device 200 by the operator. Whether or not the weighting data W is used is also input. Further, in order to identify the weighting data FL, frequencies are specified when the amplitude values are p0, p1, p2 and p3. From these, weighting data FL consisting of weighting data for each frequency is created. In the example of FIG. 3D, a frequency at which the amplitude value becomes 0 is specified. Further, a threshold value for an amplitude accumulation value in the waveform analysis device 200 is set via the operator console 100. The various parameters input in this manner are transmitted to the waveform analysis device 200 via the main body side communication unit 102 with information specifying the waveform analysis device 200 added. Then, in the operator console 100, this process is repeated to transmit the parameters to each waveform analysis device 200. When the waveform analysis device 200 determines that the information received via the remote side communication unit 202 is a parameter setting for itself, based on the parameters included in the received information, the control unit 204 sets the acquired threshold values as its own threshold values, and also sets the weighting data W and FL to the front-stage weighting section 207 and the later-stage weighting section 209, and further generates timing signals t1 and t2.

Next, in a detection flow, the waveform analysis device 200 acquires amplitude accumulation values of the accumulation unit 210 obtained based on the timing signals t1 and t2, and then determines whether the amplitude accumulation values exceed the threshold value. If the threshold value is exceeded, it is determined that trouble has occurred, and the determination result information specifying the waveform analysis device 200 is added to the determination result and transmitted via the remote side communication section 202. Further, the waveform analysis device 200 marks the data for several minutes before and after the occurrence of the trouble with respect to sampling data output from the shift store unit 205 to the memory 211 so as not to be overwritten. The data in the memory 211 are later read upon request from the operator console 100. When the operator console 100 receives trouble occurrence information from the waveform analysis device 200, it displays on the monitor that an abnormality has occurred at the location where the waveform analysis device 200 is mounted.

The operator console 100, which is a personal computer, can batch-process a series of steps of (1) reading sampling data, which is sent from the shift store unit 205 of the waveform analysis device 200 to the control unit 204, from the memory 211, (2) weighting n detection signals whose sampling period is shifted by 1 or r with weighting data W, (3) performing a discrete Fourier transform using the n detection signals, (4) weighting the obtained amplitude values with weighting data FL, (5) obtaining amplitude accumulation values, and (6) determining based on the threshold values, with software stored in itself in the same manner as the waveform analysis device 200. The operator console 100 can also reproduce what occurred in the waveform analysis device 200, for example, it is possible to display and analyze on a monitor what kind of discrete Fourier transform results were obtained when the abnormality was detected.

### [Application Example]

Hereinafter, the following describes an example of applying a waveform analysis device to a semiconductor manufacturing system 2 including a transport robot. The settings in this embodiment are as follows. Besides, the detection about electromagnetic waves is not performed.

| Detection target: | Vibration |
|---|---|
| Sampling period: | 500µsec (fs: 2KHz) |
| Arithmetic period CL: | 500µsec (2KHz) |
| Number of data n: | 256 (500µsec×256=128msec) |
| Frequency range (n/2)Δf: | 1KHz |
| Frequency resolution Δf: | 7.8125Hz |

| Detection target: | Sound |
|---|---|
| Sampling period: | 25µsec (fs:40KHz) |
| Arithmetic period CL: | 150 µsec (r=6) |
| Number of data n: | 256 (6.4msec) |
| Frequency range (n/2)Δf: | 20KHz |
| Frequency resolution Δf: | 156.25Hz |

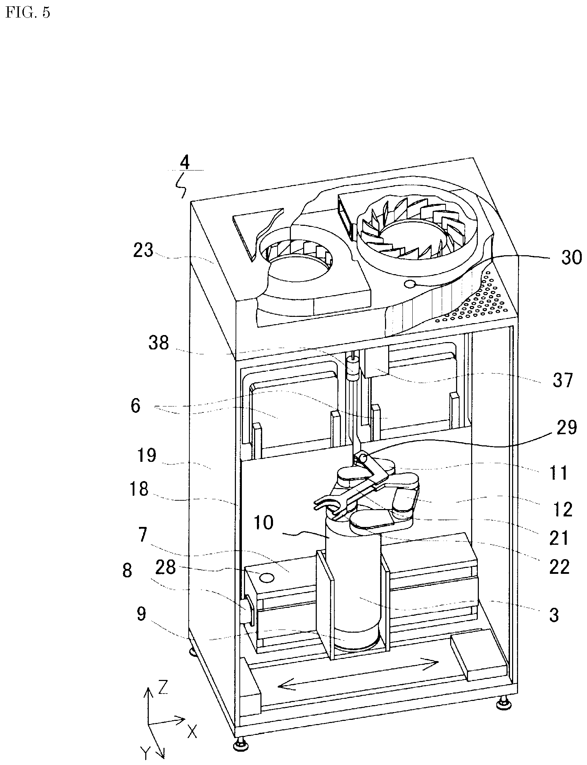

In the semiconductor manufacturing system 2, various treatments are performed on surface of a semiconductor wafer under a prescribed atmosphere in a processing section. A load lock chamber exists in front of the processing section to relay between air atmosphere and vacuum atmosphere. The process of transferring semiconductor wafers stored in a FOUP (Front-Opening Unified Pod) to the load lock chamber is performed by an EFEM (Equipment Front End Module) 4, which is one form of the transport device shown in FIG. 5.

Each of EFEMs 4 and 14 has a load port 6 that places the FOUP on its back side and opens and closes its lid, and a transport robot 3 that removes semiconductor wafers stored inside the FOUP and inserts them into the load lock chamber.

The transfer robot 3 included in the EFEM 4 shown in FIG. 5 is mounted on a traveling mechanism 7, and the traveling mechanism 7 moves the transport robot 3 (object to be transported) in a straight-line direction within a horizontal plane. The traveling mechanism 7 includes a pair of unillustrated guide tracks for guiding the transport robot 3 in a prescribed direction within the horizontal plane, an unillustrated feed screw mechanism arranged parallel to the guide tracks, and a traveling drive motor 8 for rotating a screw shaft of the feed screw mechanism. Besides, the traveling drive motor 8 and the feed screw mechanism are provided with bearings to smoothly rotate shaft members for driving, and guide rails are provided with ball retainers to reduce sliding resistance of slide blocks that slide and move on the rails. These friction-reducing members such as bearings and ball retainers are subject to wear and deterioration of grease applied to the interior due to long-term operation, which causes vibration during operation. The traveling mechanism 7 is equipped with a waveform analysis device 28 (represented by only one illustration) closely to each of these friction-reducing members to be measured. A sensor unit of the waveform analysis device 28 is an acceleration sensor that detects vibrations.

The transport robot 3 is provided with a pair of arm bodies 11 and 12 symmetrically. The arm body 11 is rotatably attached to a body 10 via bearings and has a configuration that can be rotated in a horizontal plane. Fingers 21 and 22 are provided at the tips of the arm bodies 11 and 12 via bearings. The arm body 11 has multiple joints and can extend and retract with the finger 21 facing in a prescribed direction, allowing the semiconductor wafer (to be transported) supported on the finger 21 to be transported to a prescribed position. The arm body 12 also has multiple joints and can extend and retract with the finger 22 facing in a prescribed direction, allowing the semiconductor wafer supported on the finger 22 to be transported a prescribed position.

The fingers 21 and 22 move forward and backward independently by the extension and retraction of arm bodies 11 and 12. In FIG. 5, a waveform analysis device 29 is mounted closely to the bearing of the finger 21 to be measured. The waveform analysis device 29 is also provided for other measurement objects of the transport robot 3, and not all are illustrated. The waveform analysis device 29 also includes an acceleration sensor as a sensor unit 203 in the same manner as the waveform analysis device 28.

Objects to be measured in the transport robot 3 include cross roller bearings, radial bearings, and the like. These bearings support a radial load, a thrust load, and a moment load on the shaft, for example, in the arm bodies 11 and 12, and they deteriorate or break due to long-term use.

The internal space of EFEM 4 is surrounded on all four sides by partition members each composed of a frame 18 and a cover 19, and the ceiling portion of EFEM 4 is equipped with a FFU (Fun Filter Unit) 23. The FFU 23 filters the air introduced by rotations of a fan and supplies it as clean air to the inside of EFEM 4. The dust generated by the operation of the transport robot 3 is discharged out of the EFEM 4 by the downflow of clean air supplied from the FFU 23, and the inside of the EFFM 4 is constantly maintained in a clean atmosphere. A waveform analysis device 30 is mounted closely to the bearing of the fan. A video camera 37 is disposed in the internal clean space of the EFEM 4, and ordinarily captures the operation of the transport robot 3 and other machinery, and records the image as recorded data on a non-illustrated recording device such as a hard disk or a memory.

The EFEM 4 is internally fixed with a waveform analysis device 38 for measuring sound generated by operation of the transport robot 3, and constantly detects the sound generated by the operation of the transport robot 3 while the transport robot 3 is operating. A sensor unit 203 included in the waveform analysis device 38 is a microphone. In addition to contacts between mechanical elements, it is also assumed that the semiconductor wafers mounted on the fingers 21 and 22 may come into contact with resin tubes, wiring cables, or metals during transportation. Since the sound is information that can be acquired without selecting the installation location, the waveform analysis device 38 for measuring sound is suitable for applications covering a wide range. When an abnormality is detected in the amplitude accumulation value obtained by the waveform analysis device 38, the video camera 37 saves image data recorded in the preceding and following minutes before and after in a storage device without overwriting. With the above configuration, when an abnormality such as contact or collision of the wafers occurs, which may cause a significant loss of quality, the operator can immediately recognize the occurrence of the abnormality. Furthermore, by checking the saved image data, it is possible to grasp what kind of abnormality has occurred, and to solve the trouble in a short time.

### [Measurement Results]

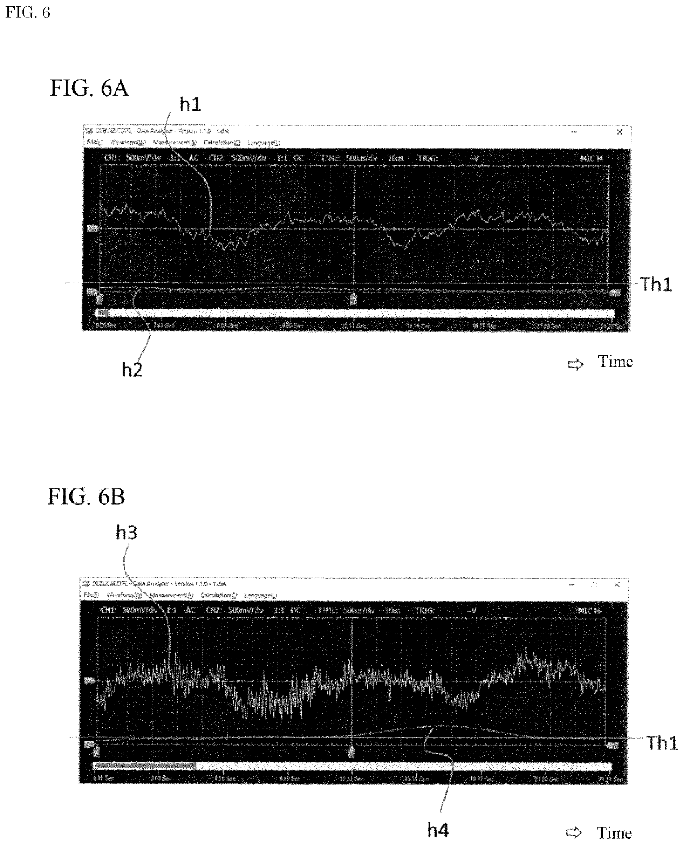

Each of FIG. 6A and FIG. 6B shows an example in which a waveform analysis device 30 measures vibration with respect to a fan bearing. FIG. 6A shows normal state and FIG. 6B shows abnormal state. The abnormality is experimentally set so that slight rubbing occurs. In each figure, a horizontal axis is time. Waveforms h1 and h3 indicate measurement signals (raw waveforms) from the sensor unit. Waveforms h2 and h4 are amplitude accumulation values obtained from the accumulation unit. The setting for the waveform analysis device 30 are the sampling period and number of data for vibration shown previously, and a window function is used as the weighting data W set in the front-stage weighting unit 207. Further, the weighting data FL is not set in the later-stage weighting unit 209, and the accumulation unit directly adds each frequency calculated by the discrete Fourier transform unit.

When observing the waveform h3 of FIG. 6B, the frequency is uniformly disturbed with respect to the waveform h1 of FIG. 6A. In this state, it is not possible to determine whether natural vibration is occurring and disturbing the system or whether impulses are occurring. On the other hand, when observing the waveform h4 of FIG. 6B, it can be seen that the amplitude accumulation value tends to increase overall with respect to the waveform h2 of FIG. 6A, and that an impulse, that is, a discontinuous oscillation, is generated. Each figure shows a certain threshold value Th1. On observing FIG. 6B, the threshold value Th1 exceeds for nearly 10 seconds. It can be inferred that the bearing slips and generates discontinuous vibrations. If such a slip is left for a long time, the bearing will wear out and lead to failure.

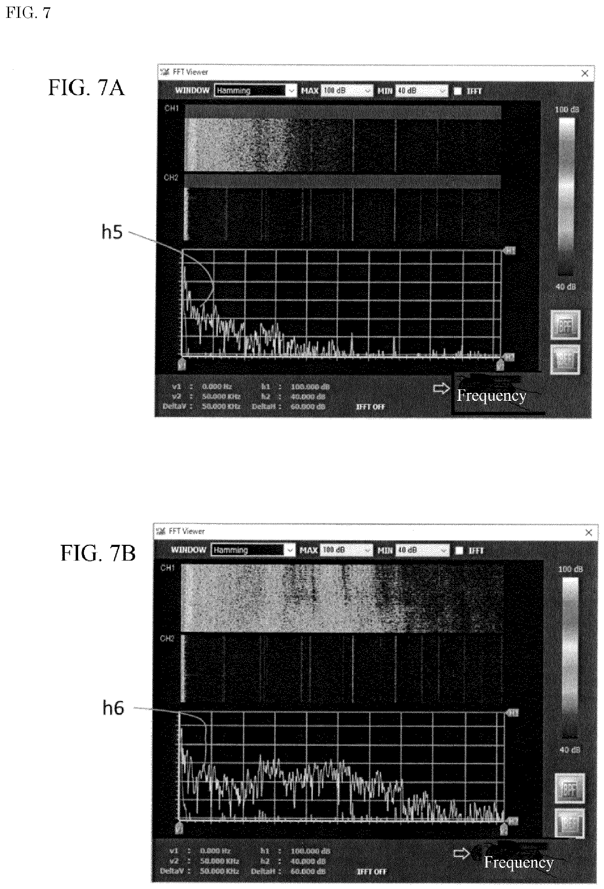

Each of FIG. 7A and FIG. 7B shows a result of the discrete Fourier transform obtained by batch processing by the operator console software. FIG. 7A shows a plot h5 of amplitude value at each frequency component under normal conditions, and FIG. 7B shows a plot h6 of amplitude value at each frequency component under abnormal conditions. In the abnormal conditions, it can be observed that the amplitude value increases in any frequency component.

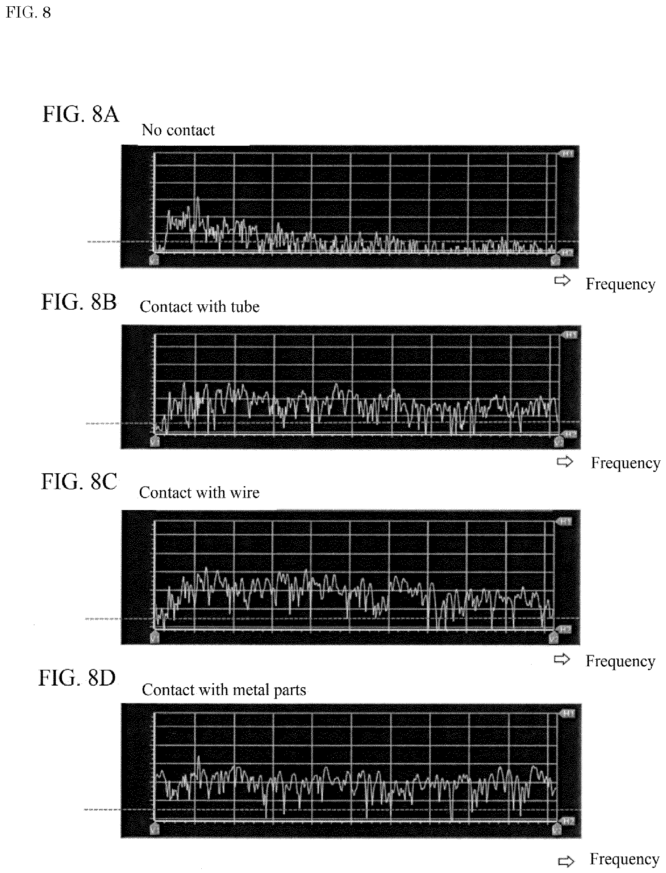

Each of FIG. 8A to FIG. 8D shows a result of discrete Fourier transform of the detection signal from the waveform analysis device 38 whose measurement object is sound. The sound is detected by experimentally contacting a semiconductor wafer with a component of the semiconductor manufacturing system 2. A result of the discrete Fourier transform in FIG. 8 is obtained by batch processing the detection signal obtained by the waveform analysis device 38 by experimentally contacting tubes, wires, and metal parts to the semiconductor wafer with software of the operator console. A window function is used as a weighting data W, and a weighting data FL is not set. **In** addition, a microphone is used for the sensor unit of the waveform analysis device 38 in order to detect sound.

FIG. 8A shows a result of discrete Fourier transform when no contact occurs, FIG. 8B shows a result of discrete Fourier transform when a tube is in contact, FIG. 8C shows a result of discrete Fourier transform when a wire is in contact, and FIG. 8D shows a result of discrete Fourier transform when a metal part is in contact. Similarly, in each result, a large amplitude value is detected over a wide range across all frequencies upon contact, indicating that discontinuous vibration occurs. Therefore, even with flexible objects such as resin tubes or wiring cables, as with metal parts, there is a clear difference in the amplitude accumulation value compared to the non-contact condition, and an abnormality can be detected by setting a threshold value.

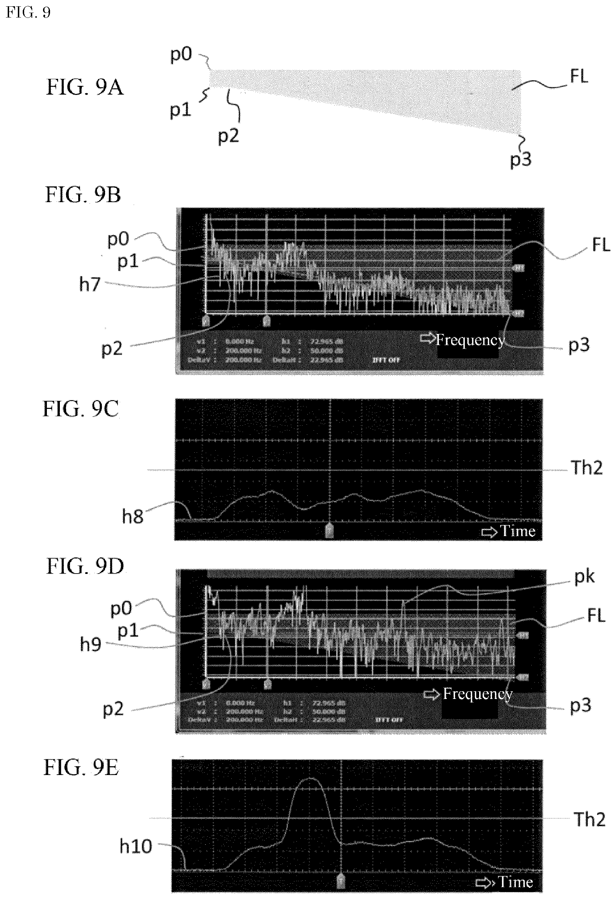

Each of FIG. 9A to FIG. 9E shows an example of detection of vibration (not sound) when a semiconductor wafer is contacted with the FOUP. This example is also obtained by batch processing with the software of the operator console. A window function is used as a weighting data W, and the weighting data FL shown in FIG. 9A is used as a weighting data FL.

FIG. 9B and FIG. 9C show a plot h7 of amplitude value and an amplitude accumulation value h8 at each frequency component obtained as a result of the discrete Fourier transform during normal states. FIG. 9D and FIG. 9E show a plot h9 of amplitude value and an amplitude accumulation value h10 at each frequency component obtained as a result of discrete Fourier transform at the time of abnormality. FIG. 9B and FIG. 9D overlay the ranges to be weighted with the weighting data FL. Comparing FIG. 9C and FIG. 9E, there is a clear difference between the amplitude accumulation value and the non-contact state, and an abnormality can be detected by setting a threshold value Th2 (FIG. 9E). In FIG. 9D, there appear frequencies having amplitude values beyond the range weighted by the weighting data FL. Since some of peaks are not observed in FIG. 9B (eg, pk in FIG. 9D), so it is assumed that the amplitude value is increased due to resonance of the mechanical elements. Such peaks are different from impulses that uniformly amplify over a wide range. The weighting data FL can reduce an effect of a specific frequency having a large amplitude value.

In the above embodiment, the waveform analysis device and the operator console communicate wirelessly, but may be wired. Further, if the processing capacity of the arithmetic unit 201 is high, a single arithmetic unit 201 can correspond in real time to a sensor that detects a plurality of physical phenomena such as vibration and sound, sound and electromagnetic waves, etc. in one waveform analysis device. In this case, for example, a shift store unit, a front-stage weighting unit, and a later-stage weighting unit may be provided for each sensor unit, and the control unit and the discrete Fourier transform unit may be shared.

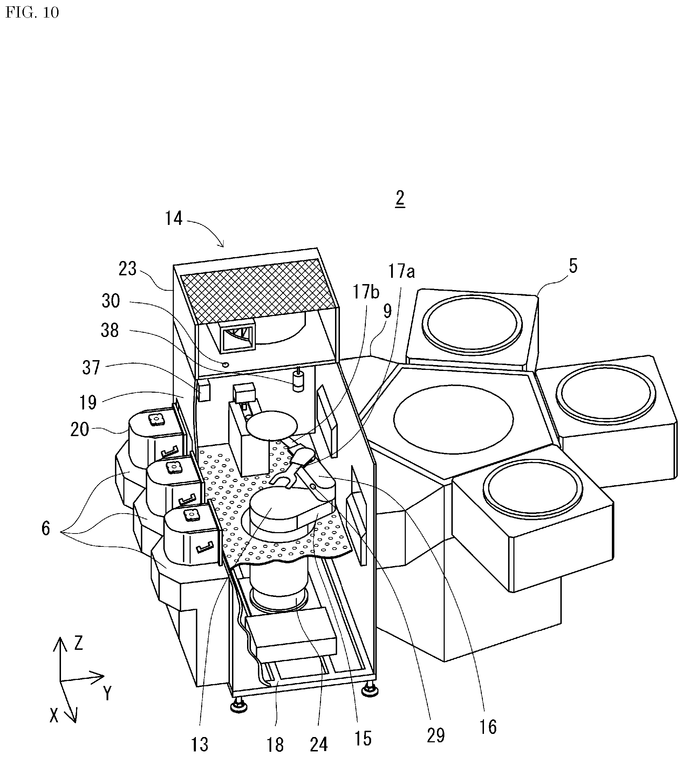

In the above, the EFEM 4 is shown as an example of a transport device in which the waveform analysis device in the example is mounted. The EFEM 4 is obtained by mounting a transport robot 3 on the traveling mechanism 7 and moving it in a straight line in a horizontal plane, but may be mounted on a transport device having another configuration. FIG. 10 shows an EFEM 14 as an example of another transport device. A processing section 5 performs various types of processing on the surface of the semiconductor wafer under a prescribed atmosphere. A load lock chamber 9 exists in front of the processing section to relay between air atmosphere and vacuum atmosphere. The EFEM 14 performs processing for transferring semiconductor wafers stored in the FOUP 20 to the load lock chamber 9 in the same manner as the EFEM 4. The transport robot 13 provided in the EFEM 14 differs from the EFEM 4 in that its base 24 is fixed to a frame 18 on a floor of the EFEM 14. The transport robot 13 includes at least a first arm 15 whose base end is provided rotatably with respect to the base 24, a second arm 16 whose base end is provided rotatably at the tip of the first arm 15, and upper and lower fingers 17a and 17b whose respective base ends are rotatably provided at the tip of the second arm 16. The first arm 15, the second arm 16, the upper and lower fingers 17a and 17b are provided with non-illustrated drive motors and reduction gears for individually rotating them. These first arm 15, second arm 16, and upper and lower fingers 17a and 17b perform synchronous interpolation operations, so that the transport robot 13 can transport the semiconductor wafer supported by the upper and lower fingers 17a and 17b to a prescribed position without the traveling mechanism 7.

FIG. 10 includes a waveform analysis device 29 mounted near the bearings of the fingers 17a and 17b to be measured. The waveform analysis device 29 is also provided for other measurement objects of the transport robot 13, and not all are shown. In addition, an FFU 23 is mounted on a ceiling of the EFEM 14. Due to downflow of clean air supplied from the FFU 23, dust generated by the operation of the transport robot 13 is discharged outside the EFEM 14, and the inside of the EFEM 14 is always maintained in a clean atmosphere. A waveform analysis device 30 is mounted near the fan bearing. A video camera 37 is disposed in the internal clean space of the EFEM 14, constantly captures the operation of the transport robot 13 and other machinery, and records image as recorded data on a non-illustrated recording device such as a hard disk or memory.

A waveform analysis device 38 is fixed on the inside of the EFEM 14 to measure sound generated by operation of a transport robot 13. While the transport robot 13 is operating, sound generated by the operation of the transport robot 3 is always detected. A sensor unit 203 provided in the waveform analysis device 38 is a microphone. Furthermore, when an abnormality is detected in amplitude accumulation values obtained by the waveform analysis device 38, an image data recorded by the video camera 37 for several minutes before and after is stored in a storage device without being overwritten. With the above configuration, when an abnormality such as contact or collision of the wafers occurs, which may greatly deteriorate the quality, the operator can immediately recognize an occurrence of the abnormality. Furthermore, by checking the saved image data, it is possible to grasp what kind of abnormality has occurred, and it is possible to solve the trouble in a short time.

### Explanation of referenced numerals

- 2: semiconductor manufacturing system
- 3, 13: transport robot
- 4, 14: EFEM
- 5: processing section
- 6: load port
- 7: traveling mechanism
- 8: traveling drive motor
- 9: load lock chamber
- 10: body
- 11, 12: arm body
- 15: first arm
- 16: second arm
- 17a, 17b: upper and lower fingers
- 18: frame
- 19: cover
- 20: FOUP
- 21, 22: finger
- 28, 29, 30, 38, 200: waveform analysis device
- 37: video camera
- 100: operator console
- 102: main body side communication unit
- 201: arithmetic unit
- 202: remote side communication unit
- 203: sensor unit
- 204: control unit
- 205: shift store unit
- 206: storage unit
- 207: front-stage weighting unit
- 208: discrete Fourier transform unit
- 209: later-stage weighting unit
- 210: arithmetic unit
- 211: memory

## Claims

1. A waveform analysis device (200) for detecting a physical phenomenon, such as vibration, sound, and electromagnetic waves, that occurs during operation of machinery and for analyzing a detection signal, comprising:
a sensor unit (203) for detecting the physical phenomenon;
a discrete Fourier transform unit (208) for performing discrete Fourier transform on the detection signal transmitted from the sensor unit (203);
a later-stage weighting unit (209) for setting amplitude values at each frequency generated by the discrete Fourier transform unit (208) that exceed a prescribed upper-limit value to said prescribed upper-limit value; and
an accumulation unit (210) for accumulating the amplitude values of each frequency weighted by the later-stage weighting unit (209).

2. The waveform analysis device (200) according to claim 1, wherein the discrete Fourier transform unit (208) performs discrete Fourier transform by shifting n consecutive detection signals obtained from the sensor unit (203) at a prescribed sampling period by r; wherein r is an integer from 1 to n/16, and n is a power of 2 greater than or equal to 256.

3. The waveform analysis device (200) according to claim 1, further comprising:
a front-stage weighting unit (207) for weighting the n detection signals with a window function.

4. The waveform analysis device (200) according to claim 1, wherein the later-stage weighting unit (209) subtracts a weighting that changes according to the frequency from the amplitude values of each frequency generated by the discrete Fourier transform unit (208), and weights the amplitude values to zero when the amplitude values are negative.

5. The waveform analysis device (200) according to claim 1, wherein abnormal occurrence is detected when an addition value added by the accumulation unit (210) exceeds a prescribed threshold value.

6. The waveform analysis device (200) according to claim 1, wherein the upper-limit value is set by an operator console.

7. A transport robot (3, 13) provided with an arm body (11, 12), a finger (21, 22) provided at a tip of the arm body (11, 12) via bearings and carrying objects to be transported, and a waveform analysis device (200) according to claim 1 for calculating a detection signal of a physical phenomenon, such as vibration, sound, and electromagnetic waves, generated by the finger (21, 22).

8. A traveling mechanism (7) provided with a guide trajectory, a traveling drive motor (8) for transporting an object to be transported along the guide trajectory, and a waveform analysis device (200) according to claim 1 for calculating a detection signal of a physical phenomenon, such as vibration, sound, and electromagnetic waves, generated in the guide trajectory.

9. A transport device (4) provided with the transport robot (3, 13) claimed in claim 7.

10. A transport device (4) provided with the transport robot (3. 13) claimed in claim 7 and the traveling mechanism (7) claimed in Claim 8, wherein the traveling mechanism (7) is configured to transport the transport robot (3, 13) along the guide trajectory.

11. A waveform analysis method for detecting a physical phenomenon, such as vibration, sound, and electromagnetic waves, that occurs during operation of machinery by a physical sensor (203) and for analyzing waveform of detected signal, comprising:
a step performing a discrete Fourier transform of a detection signal of the physical sensor;
a step weighting to a prescribed upper-limit value for amplitude values of each frequency generated by the discrete Fourier transform if the amplitude values exceed the prescribed upper-limit; and
a step adding the amplitude values of each weighted frequency.

## Patentansprüche

1. Wellenformanalysevorrichtung (200) zum Erfassen eines physikalischen Phänomens, wie beispielsweise Vibration, Schall und elektromagnetischer Wellen, das während eines Betriebs einer Maschinerie auftritt, und zum Analysieren eines Erfassungssignals, mit:
einer Sensoreinheit (203) zum Erfassen des physikalischen Phänomens;
einer Einheit (208) für diskrete Fourier-Transformation zum Durchführen diskreter Fourier-Transformation auf dem Erfassungssignal, das von der Sensoreinheit (203) übertragen wird;
einer nachstufigen Gewichtungseinheit (209) zum Setzen von Amplitudenwerten bei jeder Frequenz, die durch die Einheit (208) für diskrete Fourier-Transformation erzeugt werden, die einen vorgeschriebenen oberen Grenzwert überschreiten, auf den vorgeschriebenen oberen Grenzwert; und
einer Akkumulationseinheit (210) zum Akkumulieren der Amplitudenwerte jeder Frequenz, die durch die nachstufige Gewichtungseinheit (209) gewichtet werden.

2. Wellenformanalysevorrichtung (200) nach Anspruch 1, bei der die Einheit (208) für diskrete Fourier-Transformation eine diskrete Fourier-Transformation durch Verschieben von n aufeinanderfolgenden Erfassungssignalen, die von der Sensoreinheit (203) mit einem vorgeschriebenen Abtastungszeitraum erhalten werden, um r durchführt; bei der r eine ganze Zahl von 1 bis n/16 ist, und n eine Potenz von 2 größer oder gleich 256 ist.

3. Wellenformanalysevorrichtung (200) nach Anspruch 1, ferner mit:
einer vorstufigen Gewichtungseinheit (207) zum Gewichten der n Erfassungssignale mit einer Fensterfunktion.

4. Wellenformanalysevorrichtung (200) nach Anspruch 1, bei der die nachstufige Gewichtungseinheit (209) eine Gewichtung, die sich gemäß der Frequenz ändert, von den Amplitudenwerten jeder Frequenz, die durch die Einheit (208) für diskrete Fourier-Transformation erzeugt werden, subtrahiert und die Amplitudenwerte auf null gewichtet, wenn die Amplitudenwerte negativ sind.

5. Wellenformanalysevorrichtung (200) nach Anspruch 1, bei der ein abnormales Auftreten erfasst wird, wenn ein Additionswert, der durch die Akkumulationseinheit (210) addiert wird, einen vorgeschriebenen Schwellenwert überschreitet.

6. Wellenformanalysevorrichtung (200) nach Anspruch 1, bei der der obere Grenzwert durch eine Bedienerkonsole festgelegt wird.

7. Transportroboter (3, 13), der mit einem Armkörper (11, 12), einem Finger (21, 22), der an einer Spitze des Armkörpers (11, 12) über Lager vorgesehen ist und zu transportierende Objekte trägt, und einer Wellenformanalysevorrichtung (200) nach Anspruch 1 zum Berechnen eines Erfassungssignals eines physikalischen Phänomens, wie beispielsweise Vibration, Schall und elektromagnetischer Wellen, das durch den Finger (21, 22) erzeugt wird, versehen ist.

8. Bewegungsmechanismus (7), der mit einer Führungsbahn, einem Bewegungsantriebsmotor (8) zum Transportieren eines zu transportierenden Objekts entlang der Führungsbahn und einer Wellenformanalysevorrichtung (200) nach Anspruch 1 zum Berechnen eines Erfassungssignals eines physikalischen Phänomens, wie beispielsweise Vibration, Schall und elektromagnetischer Wellen, das in der Führungsbahn erzeugt wird, versehen ist.

9. Transportvorrichtung (4), die mit dem Transportroboter (3, 13), der in Anspruch 7 beansprucht wird, versehen ist.

10. Transportvorrichtung (4), die mit dem Transportroboter (3. 13), der in Anspruch 7 beansprucht wird, und dem Bewegungsmechanismus (7), der in Anspruch 8 beansprucht wird, versehen ist, bei der der Bewegungsmechanismus (7) dazu ausgebildet ist, den Transportroboter (3, 13) entlang der Führungsbahn zu transportieren.

11. Wellenformanalyseverfahren zum Erfassen eines physikalischen Phänomens, wie beispielsweise Vibration, Schall und elektromagnetischer Wellen, das während eines Betriebs einer Maschinerie auftritt, durch einen physikalischen Sensor (203) und zum Analysieren einer Wellenform eines erfassten Signals, umfassend:
einen Schritt, der eine diskrete Fourier-Transformation eines Erfassungssignals des physikalischen Sensors durchführt;
einen Schritt, der auf einen vorgeschriebenen oberen Grenzwert für Amplitudenwerte jeder Frequenz, die durch die diskrete Fourier-Transformation erzeugt werden, gewichtet, falls die Amplitudenwerte die vorgeschriebene obere Grenze überschreiten; und
einen Schritt, der die Amplitudenwerte jeder gewichteten Frequenz addiert.

## Revendications

1. Dispositif d'analyse de forme d'onde (200) pour détecter un phénomène physique, tel qu'une vibration, un son et des ondes électromagnétiques, qui se produit pendant le fonctionnement d'une machine et pour analyser un signal de détection, comprenant :
une unité de détection (203) pour détecter le phénomène physique :
une unité de transformée de Fourier discrète (208) pour effectuer une transformée de Fourier discrète sur le signal de détection transmis par l'unité de détection (203) ;
une unité de pondération ultérieure (209) pour fixer les valeurs d'amplitude à chaque fréquence générée par l'unité de transformée de Fourier discrète (208) qui dépassent une valeur limite supérieure prescrite à ladite valeur limite supérieure prescrite ; et
une unité d'accumulation (210) pour accumuler les valeurs d'amplitude de chaque fréquence pondérée par l'unité de pondération ultérieure (209).

2. Dispositif d'analyse de forme d'onde (200) selon la revendication 1, dans lequel l'unité de transformée de Fourier discrète (208) effectue une transformée de Fourier discrète en décalant n signaux de détection consécutifs obtenus à partir de l'unité de détection (203) à une période d'échantillon prescrite par r ; dans lequel r est un nombre entier de 1 à n/16, et n est une puissance de 2 supérieure ou égale à 256.

3. Dispositif d'analyse de forme d'onde (200) selon la revendication 1, comprenant en outre :
une unité de pondération avant (207) pour pondérer les n signaux de détection avec une fonction de fenêtre.

4. Dispositif d'analyse de forme d'onde (200) selon la revendication 1, dans lequel l'unité de pondération ultérieure (209) soustrait une pondération qui change en fonction de la fréquence des valeurs d'amplitude de chaque fréquence générée par l'unité de transformée de Fourier discrète (208), et pondère les valeurs d'amplitude à zéro lorsque les valeurs d'amplitude sont négatives.

5. Dispositif d'analyse de forme d'onde (200) selon la revendication 1, dans lequel un événement anormal est détecté lorsqu'une valeur ajoutée par l'unité d'accumulation (210) dépasse une valeur seuil prescrite.

6. Dispositif d'analyse de forme d'onde (200) selon la revendication 1, dans lequel la valeur limite supérieure est fixée par une console d'opérateur.

7. Robot de transport (3, 13) muni d'un corps de bras (11, 12), d'un doigt (21, 22) placé à l'extrémité du corps de bras (11, 12) par l'intermédiaire de roulements et portant des objets à transporter, et dispositif d'analyse de forme d'onde (200) selon la revendication 1 pour calculer un signal de détection d'un phénomène physique, tel qu'une vibration, un son et des ondes électromagnétiques, généré par le doigt (21, 22).

8. Mécanisme de déplacement (7) muni d'une trajectoire de guidage, d'un moteur d'entraînement de déplacement (8) pour transporter un objet à transporter le long de la trajectoire de guidage, et d'un dispositif d'analyse de forme d'onde (200) selon la revendication 1 pour calculer un signal de détection d'un phénomène physique, tel qu'une vibration, un son et des ondes électromagnétiques, généré dans la trajectoire de guidage.

9. Dispositif de transport (4) équipé du robot de transport (3, 13) selon la revendication 7.

10. Dispositif de transport (4) équipé du robot de transport (3, 13) selon la revendication 7 et du mécanisme de déplacement (7) selon la revendication 8, dans lequel le mécanisme de déplacement (7) est configuré pour transporter le robot de transport (3, 13) le long de la trajectoire de guidage.

11. Procédé d'analyse de forme d'onde pour détecter un phénomène physique, tel que la vibration, le son et les ondes électromagnétiques, qui se produit pendant le fonctionnement d'une machine par un capteur physique (203) et pour analyser la forme d'onde du signal détecté, comprenant :
une étape consistant à effectuer une transformée de Fourier discrète d'un signal de détection du capteur physique ;
une étape consistant à pondérer jusqu'à une valeur limite supérieure prescrite les valeurs d'amplitude de chaque fréquence générée par la transformée de Fourier discrète si les valeurs d'amplitude dépassent la limite supérieure prescrite ; et
une étape consistant à ajouter les valeurs d'amplitude de chaque fréquence pondérée.
